# EUROPEAN PATENT SPECIFICATION

(11) **EP 2 510 397 B1**
(45) Date of publication and mention of the grant of the patent: **14.01.2015**
(21) Application number: 10796182.3
(22) Date of filing: 08.12.2010
(51) Int. Cl.: G03F 7/00, G03F 1/24, G02B 5/08, G21K 1/06

(54) **METHOD FOR MANUFACTURING A MULTILAYER STRUCTURE WITH A LATERAL PATTERN FOR APPLICATION IN THE XUV WAVELENGTH RANGE, AND BF AND LMAG STRUCTURES MANUFACTURED ACCORDING TO THIS METHOD**
VERFAHREN ZUR HERSTELLUNG EINER MEHRLAGIGEN STRUKTUR MIT SEITLICHER STRUKTURIERUNG ZUR ANWENDUNG IM XUV-WELLENLÄNGENBEREICH SOWIE NACH DIESEM VERFAHREN HERGESTELLTE BF- UND LMAG-STRUKTUREN
PROCÉDÉ DE FABRICATION D'UNE STRUCTURE MULTICOUCHE AVEC UN MOTIF LATÉRAL DESTINÉ À ÊTRE UTILISÉ DANS LA PLAGE DE LONGUEURS D'ONDE XUV, ET STRUCTURES BF ET LMAG FABRIQUÉES SELON CE PROCÉDÉ

(30) Priority: 11.12.2009 NL 2003950
(43) Date of publication of application: 17.10.2012
(73) Proprietor: PANalytical B.V., 7602 EA Almelo (NL)
(72) Inventor: BIJKERK, Frederik, NL-3735 LW Bosch en Duin (NL); VAN DER WIEL, Wilfred Gerard, NL-7521 ME Enschede (NL); VAN DER MEER, Robert, NL-7553 KM Hengelo (Ov) (NL); HEGEMAN, Petronella Emerentiana, NL-7622 EK Borne (NL)
(74) Representative: Dokter, Hendrik Daniel
(86) International application number: PCT/NL2010/050832
(87) International publication number: WO 2011/071380

(56) References cited:
- WO-A1-2007/057500
- US-A1- 2005 266 693
- US-A1- 2006 162 863
- US-A1- 2007 128 875
- US-A1- 2009 170 327
- BENBALAGH R ET AL: "Lamellar multilayer amplitude grating as soft-X-ray Bragg monochromator", NUCLEAR INSTRUMENTS & METHODS IN PHYSICS RESEARCH, SECTION - A:ACCELERATORS, SPECTROMETERS, DETECTORS AND ASSOCIATED EQUIPMENT, ELSEVIER, AMSTERDAM, NL LNKD- DOI:10.1016/J.NIMA.2004.12.015, vol. 541, no. 3, 11 April 2005 (2005-04-11), pages 590-597, XP025295685, ISSN: 0168-9002 [retrieved on 2005-04-11]
- HAUSSLER ET AL: "Quantitative TEM characterizations of La/B4C and Mo/B4C ultrathin multilayer gratings by the geometric phase method", MICROELECTRONIC ENGINEERING, ELSEVIER PUBLISHERS BV., AMSTERDAM, NL LNKD- DOI:10.1016/J.MEE.2006.10.060, vol. 84, no. 3, 15 February 2007 (2007-02-15), pages 454-459, XP005890124, ISSN: 0167-9317
- TSARFATI T ET AL: "Reflective multilayer optics for 6.7 nm wavelength radiation sources and next generation lithography", THIN SOLID FILMS ELSEVIER SEQUOIA S.A. SWITZERLAND, vol. 518, no. 5, 31 December 2009 (2009-12-31), pages 1365-1368, XP002591295, ISSN: 0040-6090
- HAUSSLER D ET AL: "TEM characterization of La/B4C multilayer systems by the geometric phase method", PHYSICA STATUS SOLIDI A WILEY-VCH GERMANY, vol. 202, no. 12, September 2005 (2005-09) , pages 2299-2308, XP002591296, ISSN: 0031-8965

## Description

The invention relates to a method for manufacturing a multilayer structure with a lateral pattern, in particular of an optical grating for application in an optical device for electromagnetic radiation with a wavelength in the wavelength range between 0.1 nm and 100 nm, comprising the steps of (i) providing a multilayer structure, and (ii) arranging a lateral pattern in the multilayer structure.

The wavelength range between 0.1 nm and 10 µm comprises the hard X-ray range (wavelength between 0.1 nm and 10 nm) and the so-called XUV range (wavelength between 10 nm and 100 nm) which includes the range around a wavelength of 13.5 nm, referred to in literature as EUV radiation, as well as radiation in the soft X-ray range of the electromagnetic spectrum.

Such an optical grating is for instance applied in the production of semiconductor circuits within the technical field of nanolithography.

A particular example of such an optical grating is a so-called nano-Bragg-Fresnel (BF) structure, which forms a combination of a reflective optical element, a Bragg structure, and a diffractive optical element, a Fresnel structure.

Another example of such an optical grating is a lamellar multilayer amplitude grating (LMAG) structure, which is applied in a monochromator for spectroscopic analysis in the XUV wavelength range.

It is known to manufacture BF structures and LMAG structures according to per se known methods, such as electron beam (EB) lithography and deep ultraviolet (DUV) lithography.

The known methods have serious drawbacks in the serial production of large arrays of nanostructures with dimensions on nanometre scale.

EB lithography is relatively expensive and time-consuming and, as a consequence of so-called proximity effects and parameter drift during exposure to the electron beam, can produce results with a poor reproducibility.

DUV photolithography encounters problems of a fundamental nature at resolution levels in the structure to be manufactured of lower than 50 nm. Furthermore, DUV photolithography is only cost-effective in mass production on very large scale.

Both methods have the drawback that the width of a lamella in a periodic lateral pattern amounts to a minimum of several hundred nanometres, while the period amounts to at least one µm.

It is an object of the invention to propose a method for manufacturing a multilayer structure with characteristic dimensions smaller than 50 nm in rapid, reproducible and cost-effective manner.

It is a particular object to propose such a method for manufacturing a nano-LMAG structure.

These objectives are realized, and other advantages gained, with a method of the type stated in the preamble, wherein according to the invention step (ii) of arranging the lateral pattern is performed by means of a method for nano-imprint lithography (NIL).

The method for nano-imprint lithography (NIL) for instance comprises at least the steps of (a) providing a stamp with a stamp pattern corresponding to the lateral three-dimensional pattern to be arranged, (b) applying a layer of a curable resist material to the multilayer structure, (c) arranging the stamp pattern, using the stamp, in the layer of resist material applied according to step (b), and curing this material, and (d) removing from the multilayer structure material not, or at least substantially not covered by resist material in accordance with the stamp pattern while forming the lateral three-dimensional pattern in the multilayer structure.

In an embodiment a metal layer is deposited, prior to step (b) or following step (c), onto the multilayer structure which is flat or provided with a lateral pattern, and is subsequently applied as etching mask.

The stamp to be provided according to the invention is for instance manufactured from Si or SiO₂ (quartz), in which the stamp pattern is arranged in accordance with a per se known method, for instance by means of electron beam lithography (EBL) or laser interference lithography.

After removal of material from the multilayer structure and forming of the lateral three-dimensional pattern in the multilayer structure in step (d), the layer of resist material is removed using a solvent, and the multilayer structure provided with a three-dimensional pattern can be subjected to a subsequent process step.

The removal of material in step (d) is for instance performed in accordance with a method for reactive ion etching (RIE), by means of an inductively coupled plasma (ICP) or according to a Bosch-type etching method.

Depending on the specifications of the multilayer structure to be manufactured, according to embodiments of the method the lateral three-dimensional pattern to be formed in the multilayer structure in step (d) is given a parallel, widening wedge-shaped or narrowing wedge-shaped form from the surface of the multilayer structure.

The resist material to be applied according to step (b) is preferably a UV-curable plastic which in cured state has a relatively low viscosity, for instance a polymethyl methacrylate (PMMA).

Depending on the specifications of the multilayer structure to be manufactured, in an embodiment of a method according to the invention step (ii) of arranging the lateral pattern is followed by step (iii) of applying a cover layer over the three-dimensional pattern.

Also a BF structure may be manufactured according to the above described method, wherein the multilayer structure comprises a stack of layers of a first material from a first group comprising carbon (C) and silicon (Si) and of layers of a second material from a second group comprising the materials from the groups of transition elements from the fourth, fifth and sixth period of the periodic system of elements.

In an embodiment the layers of the second material are selected from the group of transition elements comprising cobalt (Co), nickel (Ni), molybdenum (Mo), tungsten (W), rhenium (Re) and iridium (Ir).

Using a BF structure an optical element becomes available which can be applied for wavelength selection, focusing and collimation of radiation in the wavelength range between 0.1 nm and 100 nm with an efficiency which is not achievable with a prior art multilayer structure without lateral pattern.

The invention relates to an LMAG structure manufacturing method, wherein the multilayer structure comprises a stack of layers of a first material from a first group comprising boron (B), boron carbide (B₄C), carbon (C), silicon (Si) and scandium (Sc), and of layers of a second material from a second group comprising the materials from the groups of transition elements from the fourth, fifth and sixth period of the periodic system of elements.

In an embodiment of an LMAG structure the multilayer structure is selected from the group comprising stacks of layers of tungsten and silicon (W/Si), tungsten and boron carbide (W/B₄C), molybdenum and boron carbide (Mo/B₄C), lanthanum and boron carbide (La/B₄C), chromium and carbon (Cr/C), iron and scandium (Fe/Sc), chromium and scandium (Cr/Sc), nickel and carbon (Ni/C) and nickel vanadium and carbon (NiV/C)

In an embodiment of a multilayer structure comprising a stack of layers of lanthanum and boron carbide (La/B₄C) the layers of lanthanum and boron carbide are separated by layers of lanthanum boride (LaB), these layers functioning as diffusion barrier.

Using an LMAG structure manufactured according to the invention an optical element becomes available which can be applied for wavelength selection, focusing and collimation of radiation in the wavelength range between 0.1 nm and 100 nm with an efficiency which is not achievable with a prior art multilayer structure without lateral pattern.

The invention will be elucidated hereinbelow on the basis of exemplary embodiments, with reference to the drawing.

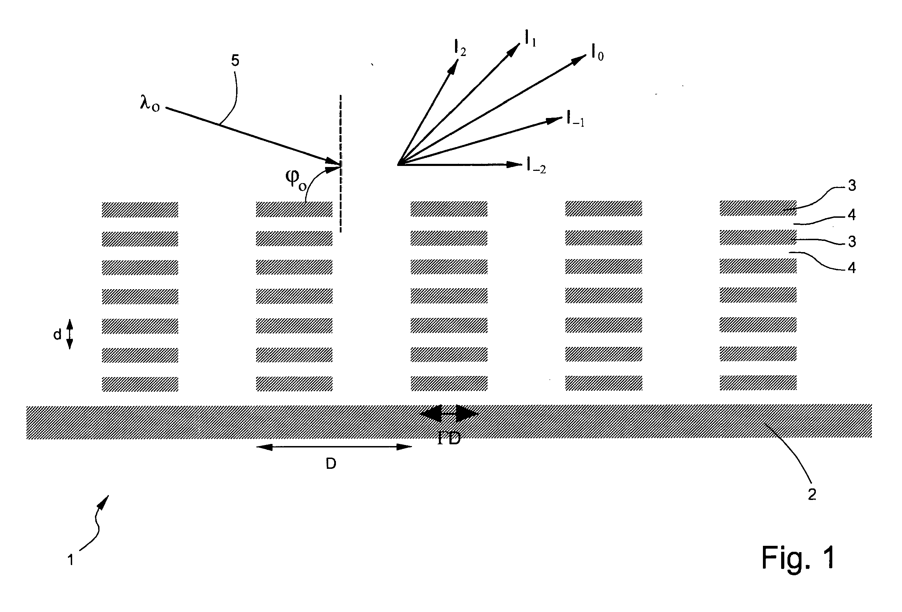

In the drawing Fig. 1 shows a schematic representation of the application of an LMAG structure 1 according to the invention as monochromator. LMAG structure 1 is formed by a substrate 2, for instance of SiO₂, having thereon a multilayer structure of thin layers 3, 4 stacked on each other with a layer period d, wherein according to the above described method a periodic lateral structure is arranged with a lateral period D and a line width ΓD. A beam of XUV radiation (represented by arrow 5) with a wavelength λ₀ is incident upon the surface of LMAG-structure 1 at an angle ϕ₀ to the surface of LMAG-structure 1. The incident beam is diffracted by LMAG-structure 1 in an exiting zeroth order beam I₀, first order beams I₁, I₋₁, second order beams I₂, I₋₂ and higher order beams (not shown).

It has been found that using an LMAG structure 1 according to the invention a monochromator can be provided which has a markedly lower dispersion (higher resolution) than with a flat, otherwise identical multilayer structure without lateral structure, wherein the reflectivity of the LMAG structure decreases to only slight extent compared to the reflectivity of the flat multilayer structure.

### Example 1

An LMAG structure 1 according to fig. 1 is constructed from a periodic stack of 120 layers 3 consisting of La (layer thickness 3.13 nm, roughness 0,38 nm) and layers 4 consisting of B₄C (layer thickness 5.05 nm, roughness 0.50 nm), with a lateral periodicity D = 500 nm and a line width coefficient r = 0.20, on a substrate 2 of Si. It is found that a beam of XUV radiation with a wavelength λ₀ = 6.7 nm, which is incident at an angle ϕ₀ upon the surface of LMAG structure 1, is reflected in zeroth order with a dispersion amounting to a factor 0.24 of the dispersion realized with an otherwise identical flat multilayer structure without lateral structure, wherein the reflectivity decreases by only 11% compared to this flat multilayer structure.

### Example 2

An LMAG structure 1 according to fig. 1 is constructed from a periodic stack of 150 layers 3 consisting of Cr (layer thickness 2.125 nm, roughness 0.312 nm) and layers 4 consisting of C (layer thickness 4.048 nm, roughness 0.338 nm), with a lateral periodicity D = 300 nm and a line width coefficient r = 0.33, on a substrate 2 of Si. It is found that a beam of XUV radiation with a wavelength λ₀ = 4.5 nm, which is incident at an angle ϕ₀ upon the surface of LMAG structure 1, is reflected in zeroth order with a dispersion amounting to a factor 0.34 of the dispersion realized with an otherwise identical flat multilayer structure without lateral structure, wherein the reflectivity decreases by only 5% compared to this flat multilayer structure.

### Example 3

An LMAG structure 1 according to fig. 1 is constructed from a periodic stack of 400 layers 3 consisting of W (layer thickness 0.715 nm, roughness 0.248 nm) and layers 4 consisting of Si (layer thickness 1.185 nm, roughness 0.384 nm), with a lateral periodicity D = 400 nm and a line width coefficient r = 0.25, on a substrate 2 of Si. A cover layer of SiO₂ with a thickness of 2 nm is applied to the structure (not shown in fig. 1). It is found that a beam of XUV radiation with a wavelength λ₀ = 2.4 nm, which is incident at an angle ϕ₀ upon the surface of LMAG structure 1, is reflected in zeroth order with a dispersion amounting to a factor 0.25 of the dispersion realized with an otherwise identical flat multilayer structure without lateral structure, wherein the reflectivity decreases by only 15% compared to this flat multilayer structure.

## Claims

1. Method for manufacturing an optical grating having a lamellar multilayer amplitude grating (LMAG) structure for application in an optical device for electromagnetic radiation with a wavelength in the wavelength range between 0.1 nm and 100 nm, comprising the steps of
(i) providing a multilayer structure, and
(ii) arranging a lateral three-dimensional pattern in the multilayer structure, **characterized in that**
step (ii) of arranging the three-dimensional lateral pattern is performed by means of a method for nano-imprint lithography (NIL).

2. Method as claimed in claim 1, wherein the method for nano-imprint lithography (NIL) comprises at least the steps of
(a) providing a stamp with a stamp pattern corresponding to the lateral three-dimensional pattern to be arranged,
(b) applying a layer of a curable resist material to the multilayer structure,
(c) arranging the stamp pattern, using the stamp, in the layer of resist material applied according to step (b), and curing this material, and
(d) removing from the multilayer structure material not covered by resist material in accordance with the stamp pattern while forming the lateral three-dimensional pattern in the multilayer structure.

3. Method as claimed in claim 2, wherein the removal of material according to step (d) is performed in accordance with a method for reactive ion etching (RIE).

4. Method as claimed in claim 2, wherein the removal of material in step (d) is performed by means of an inductively coupled plasma (ICP).

5. Method as claimed in claim 2, wherein the removal of material in step (d) is performed in accordance with a Bosch-type etching method.

6. Method as claimed in claim 2, wherein a form widening in wedge-shape from the surface of the multilayer structure is given to the lateral three-dimensional pattern to be formed in the multilayer structure in step (d).

7. Method as claimed in claim 2, wherein a form narrowing in wedge-shape from the surface of the multilayer structure is given to the lateral three-dimensional pattern to be formed in the multilayer structure in step (d).

8. Method as claimed in any of the claims 2-7, wherein the resist material to be applied according to step (b) is a UV-curable plastic which in cured state has a relatively low viscosity.

9. Method as claimed in any of the foregoing claims, wherein step (ii) of arranging the lateral pattern is followed by step (iii) of applying a cover layer over the three-dimensional pattern.

10. Method as claimed in any of the foregoing claims for manufacturing a multilayer structure with a periodic lateral pattern, in which pattern the period is smaller than 1 µm.

11. Method as claimed in any of the claims 1-10, wherein the multilayer structure comprises a stack of layers of a first material from a first group comprising boron (B), boron carbide (B₄C), carbon (C), silicon (Si) and scandium (Sc), and of layers of a second material from a second group comprising the materials from the groups of transition elements from the fourth, fifth and sixth period of the periodic system of elements.

12. Method as claimed in claim 11, wherein the multilayer structure is selected from the group comprising a stack of layers of tungsten and silicon (W/Si), tungsten and boron carbide (W/B₄C), molybdenum and boron carbide (Mo/B₄C), lanthanum and boron carbide (La/B₄C), chromium and carbon (Cr/C), iron and scandium (Fe/Sc), chromium and scandium (Cr/Sc), nickel and carbon (Ni/C) and nickel vanadium and carbon (NiV/C).

13. Method as claimed in claim 12, wherein the multilayer structure comprises a stack of layers of lanthanum and boron carbide (La/B₄C), and the layers of lanthanum and boron carbide are separated by layers of lanthanum boride (LaB).

## Patentansprüche

1. Verfahren zur Herstellung eines optischen Gitters mit einer lamellaren Mehrschichten Amplitudengitter (LMAG) Struktur zur Anwendung in einer optischen Einrichtung für elektromagnetische Strahlung mit einer Wellenlänge im Wellenlängenbereich zwischen 0,1 nm und 100 nm, umfassend die Schritte
(i) des Bereitstellens einer Mehrschichtenstruktur, und
(ii) des Anbringens eines lateralen dreidimensionalen Musters in der Mehrschichtenstruktur, **dadurch gekennzeichnet,**
**dass** der Schritt (ii) des Anbringens des dreidimensionalen lateralen Musters durch ein Verfahren für Nanoimprint Lithographie (NIL) ausgeführt wird.

2. Verfahren nach Anspruch 1, wobei das Verfahren für Nanoimprint Lithographie (NIL) zumindest die Schritte umfasst
(a) des Bereitstellens eines Stempels mit einem mit dem anzubringenden lateralen dreidimensionalen Muster korrespondierenden Stempelmuster
(b) des Anbringens auf die Mehrschichtenstruktur einer Schicht eines aushärtbaren Resistmaterials,
(c) des mittels des Stempels Anbringens des Stempelmusters in der gemäß dem Schritt (b) angebrachten Schicht Resistmaterial und des Aushärtens dieses Materials, und
(d) des Entfernens von gemäß dem Stempelmuster nicht durch Resistmaterial bedecktem Material aus der Mehrschichtenstruktur, unter Ausbildung des lateralen dreidimensionalen Musters in der Mehrschichtenstruktur.

3. Verfahren nach Anspruch 2, wobei das gemäß dem Schritt (d) Entfernen von Material nach einem Verfahren für reaktives Ionenätzen (RIE) ausgeführt wird.

4. Verfahren nach Anspruch 2, wobei das in dem Schritt (d) Entfernen von Material durch ein induktiv gekoppeltes Plasma (ICP) ausgeführt wird.

5. Verfahren nach Anspruch 2, wobei das Entfernen von Material in dem Schritt (d) gemäß einem Verfahren für Ätzen mit dem Bosch-Prozess ausgeführt wird.

6. Verfahren nach Anspruch 2, wobei dem in dem Schritt (d) auszubildenden lateralen dreidimensionalen Muster in der Mehrschichtenstruktur ein sich von der Fläche der Mehrschichtenstruktur aus keilförmig erweiternder Verlauf verliehen wird.

7. Verfahren nach Anspruch 2, wobei dem in dem Schritt (d) auszubildenden lateralen dreidimensionalen Muster in der Mehrschichtenstruktur ein sich von der Fläche der Mehrschichtenstruktur keilförmig verengender Verlauf verliehen wird.

8. Verfahren nach einem der Ansprüche 2-7, wobei das gemäß dem Schritt (b) anzubringende Resistmaterial ein UV-aushärtbarer Kunststoff ist, der in ausgehärtetem Zustand eine relativ niedrige Viskosität aufweist.

9. Verfahren nach einem der vorhergehenden Ansprüche, wobei dem Schritt (ii) des Anbringens des lateralen Musters der Schritt (iii) des Anbringens einer Deckschicht über das dreidimensionale Muster folgt.

10. Verfahren nach einem der vorhergehenden Ansprüche zur Herstellung einer Mehrschichtenstruktur mit einem periodischen lateralen Muster, worin die Periode kleiner als 1 µm ist.

11. Verfahren nach einem der Ansprüche 1-10, wobei die Mehrschichtenstruktur eine Stapelung von Schichten eines ersten Materials aus einer ersten Gruppe umfasst, die Bor (B), Borkarbid (B₄C), Kohlenstoff (C), Silizium (Si) und Scandium (Sc) umfasst, und von Schichten eines zweiten Materials aus einer zweiten Gruppe, die die Materialien aus den Gruppen Übergangselemente aus der vierten, fünften und sechsten Periode des Periodensystem der Elemente umfasst.

12. Verfahren nach Anspruch 11, wobei die Mehrschichtenstruktur aus der Gruppe ausgewählt wurde, die eine Stapelung von Schichten Wolfram und Silizium (W/Si), Wolfram und Borkarbid (W/B₄C), Molybdän und Borkarbid (Mo/B₄C), Lanthan und Borkarbid (La/B₄C), Chrom und Kohlenstoff (Cr/C), Eisen und Scandium (Fe/Sc), Chrom und Scandium (Cr/Sc), Nickel und Kohlenstoff (Ni/C) und Nickel-Vanadium und Kohlenstoff (NiV/C) umfasst.

13. Verfahren nach Anspruch 12, wobei die Mehrschichtenstruktur eine Stapelung von Schichten Lanthan und Borkarbid (La/B₄C) umfasst, und die Schichten Lanthan und Borkarbid durch Schichten Lanthanborid (LaB) getrennt sind.

## Revendications

1. Procédé de fabrication d'un réseau optique présentant une structure de réseau d'amplitude multicouche lamellaire (LMAG) à appliquer dans un dispositif optique pour un rayonnement électromagnétique avec une longueur d'onde dans la plage de longueur d'onde entre 0,1 nm et 100 nm, comprenant les étapes suivantes:
(i) fournir une structure multicouche, et
(ii) former un motif tridimensionnel latéral dans la structure multicouche, **caractérisé en ce que**
l'étape (ii) de formation du motif tridimensionnel latéral est exécutée au moyen d'un procédé de lithographie par nano-impression (NIL).

2. Procédé selon la revendication 1, dans lequel le procédé de lithographie par nano-impression comprend les étapes suivantes:
(a) fournir un tampon avec un motif d'estampillage qui correspond au motif tridimensionnel latéral à former;
(b) appliquer une couche d'une matière photorésistante durcissable à la structure multicouche;
(c) former le motif d'estampillage, en utilisant le tampon, dans la couche de matière photorésistante appliquée selon l'étape (b), et faire durcir cette matière; et
(d) enlever de la matière de structure multicouche non couverte par la matière photorésistante selon le motif d'estampillage tout en formant le motif tridimensionnel latéral dans la structure multicouche.

3. Procédé selon la revendication 2, dans lequel l'enlèvement de matière selon l'étape (d) est exécuté selon un procédé de gravure par ions réactifs (RIE).

4. Procédé selon la revendication 2, dans lequel l'enlèvement de matière à l'étape (d) est exécuté au moyen d'un plasma couplé de façon inductive (ICP).

5. Procédé selon la revendication 2, dans lequel l'enlèvement de matière à l'étape (d) est exécuté selon un procédé de gravure de type Bosch.

6. Procédé selon la revendication 2, dans lequel une forme s'élargissant en forme de coin à partir de la surface de la structure multicouche est donnée au motif tridimensionnel latéral pour être formée dans la structure multicouche à l'étape (d).

7. Procédé selon la revendication 2, dans lequel une forme rétrécissant en forme de coin à partir de la surface de la structure multicouche est donnée au motif tridimensionnel latéral pour être formée dans la structure multicouche à l'étape (d).

8. Procédé selon l'une quelconque des revendications 2 à 7, dans lequel la matière photorésistante à appliquer selon l'étape (b) est un plastique durcissable aux UV qui, à l'état durci, présente une viscosité relativement basse.

9. Procédé selon l'une quelconque des revendications précédentes, dans lequel l'étape (ii) de formation du motif latéral est suivie par l'étape (iii) d'application d'une couche de couverture sur le motif tridimensionnel.

10. Procédé selon l'une quelconque des revendications précédentes pour fabriquer une structure multicouche avec un motif latéral périodique, motif dans lequel la période est inférieure à 1 µm.

11. Procédé selon l'une quelconque des revendications 1 à 10, dans lequel la structure multicouche comprend une pile de couches d'une première matière appartenant à un premier groupe comprenant le bore (B), le carbure de bore (B₄C), le carbone (C), le silicium (Si) et le scandium (Sc), et de couches d'une deuxième matière appartenant à un deuxième groupe comprenant les matières des groupes des éléments de transition appartenant aux quatrième, cinquième et sixième périodes du système périodique des éléments.

12. Procédé selon la revendication 11, dans lequel la structure multicouche est sélectionnée dans le groupe comprenant une pile de couches de tungstène et de silicium (W/Si), de tungstène et de carbure de bore (W/B₄C), de molybdène et de carbure de bore (Mo/B₄C), de lanthane et de carbure de bore (La/B₄C), de chrome et de carbone (Cr/C), de fer et de scandium (Fe/Sc), de chrome et de scandium (Cr/Sc), de nickel et de carbone (Ni/C) et de nickel vanadium et de carbone (NiV/C).

13. Procédé selon la revendication 12, dans lequel la structure multicouche comprend une pile de couches de lanthane et de carbure de bore (La/B₄C), et les couches de lanthane et de carbure de bore sont séparées par des couches de borure de lanthane (LaB).
